**Europäisches Patentamt**

**European Patent Office**

**Office européen des brevets**

(19)

(11) Veröffentlichungsnummer: **0 252 548**
**B1**

(12)

# EUROPÄISCHE PATENTSCHRIFT

(45) Veröffentlichungstag der Patentschrift:
**14.11.90**

(21) Anmeldenummer: **87201191.1**

(22) Anmeldetag: **23.06.87**

(51) Int. Cl.⁵: **C23C 16/50**

(54) **Verfahren zur Herstellung von elektrisch leitenden Formkörpern durch plasmaaktivierte chemische Abscheidung aus der Gasphase.**

(30) Priorität: **05.07.86 DE 3622614**

(43) Veröffentlichungstag der Anmeldung:
**13.01.88 Patentblatt 88/2**

(45) Bekanntmachung des Hinweises auf die Patenterteilung:
**14.11.90 Patentblatt 90/46**

(84) Benannte Vertragsstaaten:
**DE FR GB**

(56) Entgegenhaltungen:
**EP-A- 0 175 223**
**EP-A- 0 212 718**

(73) Patentinhaber: **Philips Patentverwaltung GmbH,
Wendenstrasse 35 Postfach 10 51 49,
D-2000 Hamburg 1(DE)**

(84) Benannte Vertragsstaaten: **DE**

(73) Patentinhaber: **N.V. Philips' Gloeilampenfabrieken,
Groenewoudseweg 1, NL-5621 BA Eindhoven(NL)**

(84) Benannte Vertragsstaaten: **FR GB**

(72) Erfinder: **Gärtner, Georg, Dr., Martelenberger Weg 16B,
D-5100 Aachen(DE)**
Erfinder: **Lydtin, Hans, Dr., Am Göpelschacht 9,
D-5190 Stolberg(DE)**

(74) Vertreter: **Piegler, Harald, Dipl.-Chem. et al, Philips
Patentverwaltung GmbH
Wendenstrasse 35 Postfach 10 51 49,
D-2000 Hamburg 1(DE)**

ACTORUM AG

## Beschreibung

Die Erfindung betrifft ein Verfahren zur Herstellung eines Formkörpers aus mindestens einem elektrisch leitenden Werkstoff durch eine plasmaaktivierte Abscheidung des Werkstoffs aus einer mindestens eine Ausgangsverbindung des Werkstoffs enthaltenden Gasphase auf einer aus einem zweiten elektrisch leitenden Werkstoff bestehenden Unterlage, die anschließend entfernt wird.

Ein derartiges Verfahren ist aus EP-A-0 081 270 bekannt, wobei der auf diese Weise hergestellte Formkörper eine thermionische Kathode ist. Die dabei verwendete Unterlage ist entsprechend der gewünschten Kathodengeometrie geformt. Die Unterlage ist z.B. ein Hohlzylinder und besteht z.B. aus Kupfer, Nickel, Eisen, Molybdän oder deren Legierungen. Auf die Unterlage wird, z.B. durch chemische Abscheidung aus der Gasphase (CVD-Verfahren), eine Schichtstruktur aus hochschmelzendem Metall, z.B. Wolfram, Molybdän, Tantal, Niob, Platin, Osmium, Ruthenium, Rhodium, Rhenium, Iridium oder Palladium, sowie gegebeinenfalls Emitter- und Dotierstoffen, aufgebracht. Als Ausgangsverbindungen der Metalle werden dabei z.B. deren Halogenide, Carbonyle, Trifluorphosphane, Metalloceine, β-Diketonate und Alkoholate verwendet. Die chemische Abscheidung aus der Gasphase wird z.B. durch Erzeugung eines Plasmas veranlaßt (plasmaaktiviertes CVD-Verfahren = PCVD-Verfahren). Das abschließende Entfernen der Unterlage erfolgt z.B. durch Ätzen, mechanische Bearbeitung und/oder Verdampfen durch Erhitzen.

Aus DE-A-3 117 252 ist eine Plasmaauftragvorrichtung bekannt, die eine Plasmageineratorkammer sowie eine davon getrennt angeordnete Probenkammer aufweist, wobei die Plasmageineratorkammer z.B. so geformt und bemessen ist, daß sie die Bedingungen eines Mikrowellen-Hohlraumresonators erfüllt. Die zu beschichtende Unterlage befindet sich außerhalb des Resonators in der Probenkammer, in die das Plasma zumindest teilweise extrahiert wird. Die auf der Unterlage abgeschiedenen Schichten bestehen vor allem aus Isolatoren, wie Siliziumnitrid und Siliziumdioxid, oder Halbleitern, wie Silizium; es werden aber auch elektrisch leitende Werkstoffe, wie Molybdänsilizid und Molybdän, genannt. Obwohl das Plasma in der Probenkammer unter der Wirkung eines divergenten Magnetfeldes beschleunigt wird, werden nur sehr dünne Schichten mit sehr geringen Abscheideraten erzeugt.

Aus GB-A-2 030 180 ist ein Ionen-Beschichtungsverfahren bekannt, d.h. ein Verfahren, bei dem Ionen gebildet und durch en hohes elektrisches Gleichspannungsfeld zur zu beschichtenden Unterlage hin beschleunigt werden. Dabei wird der Reaktionsraum durch ein elektrisch leitendes Rohr und zwei isolierende Stopfen gebildet, mit denen die Enden des Rohres verschlossen sind. Die Innenwandung des Rohres stellt die zu beschichtende Unterlage dar. Im Reaktionsraum wird durch eine Gleichstrom- und/oder Hochfrequenzentladung zwischen dem als Außenelektrode geschalteten Rohr und einer dünnen, rohrförmigen Innenelektrode, die sich durch die Stopfen hindurch konzentrisch im gesamten Reaktionsraum erstreckt, ein Plasma erzeugt. Wesentlich ist dabei die elektrische Isolation zwischen dem Rohr und der Innenelektrode durch den Stopfen. Die Gasphase wird durch Pyrolyse oder chemische Reduktion zersetzt, aber auch Mikrowellen oder Photolyse sind hierfür vorgesehen. Im Falle der Zersetzung der Gasphase durch Mikrowellen sollen die Mikrowellen in den Reaktionsraum eingestrahlt oder über einen Wellenleiter in den Reaktionsraum eingeleitet werden. Bei diesem bekannten Verfahren wird die Mikrowellenenergie nur zu einem Bruchteil ausgenutzt. Außerdem wird die Mikrowelleneinkopplung nach kurzer Zeit unterbrochen und es entstehen nur sehr dünne, d.h. etwa lμm dicke Schichten, da die Mikrowellen implizit über en Dielektrikum, d.h. über die isolierenden Stopfen, in den luftdicht abgeschlossenen Reaktionsraum eingekoppelt werden. Die Oberfläche des Dielektrikums im Reaktionsraum wird unweigerlich ebenfalls mit dem elektrisch leitenden Werkstoff beschichtet, wodurch die weitere Einkopplung unterbunden wird.

Der Erfindung liegt die Aufgabe zugrunde, elektrisch leitende Schichten mit hoher Ausnutzung der Mikrowellenenergie abzuscheiden und längerdauernde Beschichtungen zu ermöglichen, so daß Gesamtdicken von etwa lOμm oder mehr erreicht werden.

Diese Aufgabe wird erfindungsgemäß dadurch gelöst, daß bei einem Verfahren der eingangs genannten Art die Gasphase in einen als Mikrowellen-Hohlraumresonator ausgebildeten Reaktionsraum eingeleitet wird, dessen Innenwandung zum Teil aus zumindest einem Teil der Unterlage besteht, auf der der elektrisch leitende Werkstoff abgeschieden wird, und daß dem Reaktionsraum an einer Stelle, die von aufwachsendem elektrisch leitendem Werkstoff freigehalten wird, Mikrowellen zugeführt werden, durch die en stehendes Mikrowellenfeld im Reaktionsraum erzeugt wird.

Das stehende Mikrowellenfeld wird dadurch erzeugt, daß der Reaktionsraum geometrisch derart dimensioniert wird, daß seine räumlichen Abmessungen der Resonanzbedingung für einen vorgegebenen Wellentyp der Mikrowelle mit der Frequenz $v = c/\lambda$ genügen, wobei c = Lichtgeschwindigkeit und $\lambda$ = Wellenlänge. Dies bedeutet, daß der Reaktionsraum derart ausgebildet wird, daß er als Mikrowellen-Hohlraumresonator wirkt. Noch anders ausgedrückt, bedeutet dies, daß die Frequenz der dem Hohlraumresonator, d.h. dem Reaktionsraum, zugeführten Mikrowellen mit einer der Resonanzfrequenzen des Resonators in Übereinstimmung gebracht wird. Nähere Einzelheiten der Dimensionerung und Funktionsweise von Hohlraumresonatoren sind in den Büchern von H. Franke (Herausgeber) "Lexikon der Physik" (Stuttgart l969) S. l405 - l406 und H. Püschner "Wärme durch Mikrowellen" (Eindhoven l964) S. l75 - 20l beschrieben.

Die Erfindung beruht demnach auf dem Gedanken, die Aktivierung der chemischen Abscheidung aus der Gasphase durch das Mikrowellenplasma dadurch zu verstärken, daß die zu beschichtende Unterlage Teil der Innenwandung eines speziell konstruierten Mikrowellenresonators ist. Dadurch kann bei höheren Drucken als nach DE-A-3 ll7 252 gearbeitet werden und es werden bis zu loofach höhere Abscheideraten erzielt.

Die geometrischen Abmessungen des Resonators ergeben sich aus den Abmessungen der Unterlage, der daraus folgenden Auswahl des Resonatortyps und dem gewünschten Schwingungsmode, wobei sich natürlich je nach Anwendung bestimmte Präferenzen ergeben.

Bevorzugt wird es, einen einzigen ganz bestimmten Resonatormode über eine jeweils passend gewählte abstimmbare Einkoppelvorrichtung aus einem die Mikrowellen führenden Hohlleiter anzuregen. Dabei ist es zweckmäßig, daß en transversaler elektrischer Wellentyp (TE$_{nmp}$-Wellentyp) angeregt wird, bei dem ein Bauch oder mehrere Bäuche der senkrecht auf der Oberfläche der Unterlage endenden elektrischen Feldvektoren der Mikrowelle sich längs der Unterlage erstrecken. Dadurch bilden sich an der Oberfläche der Unterlage die höchsten Plasmadichten aus.

Um zu erreichen, daß der Reaktionsraum optimal als Mikrowellen-Hohlraumresonator wirkt, ist es zweckmäßig, bei der geometrischen Gestaltung des Reaktionsraumes Toleranzen in der Größenordnung von 0,l mm einzuhalten. Ferner sind für das optimale Funktioneren des Resonators Form, Glätte und elektrische Leitfähigkeit der inneren Wandung des Reaktionsraumes von Bedeutung.

Schichten aus elektrisch leitendem Werkstoff werden vorzugsweise auf der Innenwandung eines rotationssymmetrischen Hohlraumresonators abgeschieden. In einem derartigen Resonator bildet sich nämlich eine Modenstruktur aus, die den Resonator gegen eine Veränderung des Hohlraumdurchmessers durch die beim Abscheiden aufwachsenden Schichten unempfindlich macht. Rechteckige und kugelförmige Hohlraumresonatoren sind jedoch ebenfalls gut geeignet.

Die Güte des leeren Hohlraumresonators beträgt vorzugsweise mindestens l00, wobei technisch gute Realisierungen des erfindungsgemäßen Verfahrens Güten von 50000 erreichen. Unter der Güte ist der Quotient aus eingekoppelter Leistung zu Verlustleistung pro Periode zu verstehen. Nähere Einzelheiten sind in den obengenannten Büchern beschrieben.

Wegen der Veränderung der geometrischen Abmessungen im Laufe des Verfahrens, z.B. durch die beim Abscheiden aufwachsenden Schichten, ist es in manchen Fällen zweckmäßig, die Mikrowellenfrequenz und die Resonatorfrequenz für den gewählten Wellentyp durch mechanische und/oder elektrische Nachstimmung während der Abscheidung in Resonanz zu halten. Dies geschieht z.B. durch eine Frequenzanpassung des Mikrowellensenders über eine Regelstrecke, wobei auf minimale reflektierte Leistung nachgeregelt wird und z.B. eine intermittierende Frequenzwobbelung benutzt wird.

Weil bei längerer Dauer des erfindungsgemäßen Verfahrens, also z.B. bei der Herstellung von Schichtdicken in der Größenordnung von 20 bis

l00μm, die gegebenenfalls aus mehreren Komponenten bestehen, dadurch Kurzschlüsse auftreten könnten, daß die elektrisch leitenden Schichten auch an der Einkoppelstelle aufwachsen, also an der Stelle, an der dem Reaktionsraum Mikrowellenenergie zugeführt wird, ist es notwendig, die Einkoppelstelle von aufwachsenden elektrisch leitenden Schichten freizuhalten. Dies geschieht z.B. durch Einleiten eines Spülgases, z.B. ein Edelgas, wie Argon, an der Einkoppelstelle oder durch Einbau eines selektiv nicht beschichtbaren Isolators an der Einkoppelstelle, bei dem an der Oberfläche zum Reaktionsraum statt einer Beschichtung eine Ätzreaktion stattfindet.

Bei einer weiteren bevorzugten Ausführungsform des erfindungsgemäßen Verfahrens wird die nach außen verlängerte Unterlage relativ zum Plasma und zur übrigen Wandung des Reaktionsraumes periodisch oder aperiodisch verschoben. Durch die Verschiebung während der Abscheidung wird eine sehr gute Homogenisierung der abgescheideinen Schichten erreicht. Außerdem wird der Unterlagenbereich, auf dem abgeschieden wird, vergrößert. Ein weiterer Vorteil dieser Ausführungsform ist es, daß bei der Erzeugung homogeiner Schichten durch Hin- und Herbewegen einer längeren Unterlage relativ zum Resonator die Plasmaausdehnung auch bei Leistungssteigerung konstant bleibt und keine langen Außentaper auftreten, d.h. keine ausgedehnten Bereiche mit abweichender Dicke.

Es ist ferner zweckmäßig, die Öffnungen im Hohlraumresonator für Gaseintritt, Gasaustritt und gegebenenfalls Schleifkontaktverbindung für die Verschiebung möglichst klein zu halten. Damit wird erreicht, daß auch bei starker Erhöhung der Mikrowellenleistung im Resonator kein nennenswertes Auslecken von Mikrowellen auftritt und der Taper in der abgeschedeinen Schicht immer konstant und kleiner als die axiale Längsausdehnung des Hohlraumresonator-Reaktionsraums bleibt.

Das Entfernen, d.h. Ablösen, der abgeschiedeinen Schichten bzw. des Formkörpers von der Unterlage wird nach bekannten Verfahrensweisen vorweggenommen, wie sie z.B. in EP-A-0 08l 270 beschrieben sind.

Als Ausgangsgemisch werden alle eingangs genannten Ausgangsverbindungen, aber auch Metallheptafluordimethyloctandionate und Metall-acetylacetonate, benutzt und es werden damit die dort genannten Materialstrukturen hergestellt, z.B. auch solche, die Carbide und Oxide, wie Wolframcarbid und Thoriumoxid, enthalten.

Der Hohlraumresonator besteht zweckmäßigerweise aus Stahl oder Kupfer.

Mit dem erfindungsgemäßen Verfahren werden selbsttragende Formkörper oder Schichten aller Art hergestellt, insbesondere für Hochtemperaturanwendungen. Beispiele hierfür sind nicht nur die eingangs erwähnten thermionischen Kathoden bzw. Glühkathoden sondern auch hochschmelzende Rohre für verschiedene Anwendungen, wie Wände von Plasmakammern, Innenrohre von Hochleistungslasern und Ummantelungen im Inneren von Kernreaktoren.

Die Erfindung wird an Hand einer Zeichnung und mit Beispielen für die Herstellung von freitragenden metallischen Zylindern näher erläutert. In der Zeichnung zeigen

Fig. I eine Abscheidungsvorrichtung mit einem zylindrischen Mikrowellen-Hohlraumresonator schematisch und im Schnitt,

Fig. 2 ein Schaltschema für eine Abscheidungsvorrichtung,

Fg. 3a eine Abscheidungsvorrichtung mit einem koaxialen Mikrowellen-Hohlraumresonator schematisch und im Schnitt,

Fig. 3b die Vorrichtung nach Fig. 3a in perspektivischer Darstellung und

Fig. 4 eine Alternative zum Schaltschema nach Fig. 2.

Beispiel I

Zur Herstellung eines metallischen Zylinders mit einem Außendurchmesser D = 30 mm und einer Länge L = 23,3 mm, wobei die typischen zu erzielenden Beschichtungsdicken, d.h. die Wandstärken des Formkörpers, zwischen 50μm und 200μm liegen sollen, wird ein zylindrischer Mikrowellen-Hohlraumresonator verwendet, wie er in Fig. I schematisch dargestellt ist. Die Außenwand des zylindrischen Hohlraumresonators wird von einem Substratrohr I gebildet, das als Unterlage für die Abscheidung dient und das in einem Reaktorrohr 2 gegebenenfalls zusammengesetzt aus Einzelzylindern gut passend gestapelt ist. Zwei Resonatorendplatten 3 und 4 sind durch zwei Distanzstäbe 5 und 6 verbunden (oder werden in konstantem Abstand zueinander - ohne Distanzstäbe - von beiden Seiten hin und her bewegt) und haben einen Wandabstand von etwa 0,2 bis 0,5 mm. In der oberen Resonatorendplatte 3 befindet sich eine Einkoppelstelle in Form eines Einkoppelstiftes 7. Die Einkopplung erfolgt über eine Koaxialleitung 8, deren Innenleiter, nämlich der Einkoppelstift 7, axial etwas in den Resonator hineinragt und so die Anregung des $TM_{011}$-Modes bewirkt. Die Resonatorendplatten können zusätzlich zur Einströmung und Absaugung perforiert sein. Zugleich kann der Stift 7 dazu benutzt werden, um am Anfang das Plasma durch eine Gleichstrom-Entladung zu zünden. Von einer Gasversorgung (durch einen Pfeil 9 angedeutet) strömen die reaktiven Gase, wie durch die Pfeile I0 und II angedeutet, durch die Lücke zwischen dem Substratrohr I und der Resonatorendplatte 4 in den Resonator und werden , wie durch die Pfeile I2 und I3 angedeutet, zu einer Gasentsorgung hin abgepumpt, die durch einen Pfeil I4 angedeutet ist. Die Koaxialleitung 8 wird im Zwischenraum zwischen Innen- und Außenleiter durch ein inertes Spülgas (durch zwei Pfeile I5 und I6 angedeutet) gespült, das ebenfalls in den Resonator strömt und, wie durch die Pfeile I2 und I3 angedeutet, abgepumpt wird. Sind die reaktiven Gase z.B. $WF_6$ und $H_2$, so kann an der Einkoppelstelle en Hart- oder Weichglasfenster (nicht dargestellt) eingesetzt werden, das wegen der Ätzreaktion mit entstandenem HF nicht beschichtet wird. Die Koaxialleitung 8 und die Resonatorendplatten 3 und 4 werden in Achsenrichtung im Substratrohr I periodisch hin- und herbewegt, was durch Pfeile I7 und I8 angedeutet ist. Auf der Reaktoraußenwand sind zusätzlich noch Heizwicklungen I9 angeordnet, die eine Zusatzheizung des Substratrohres gestatten.

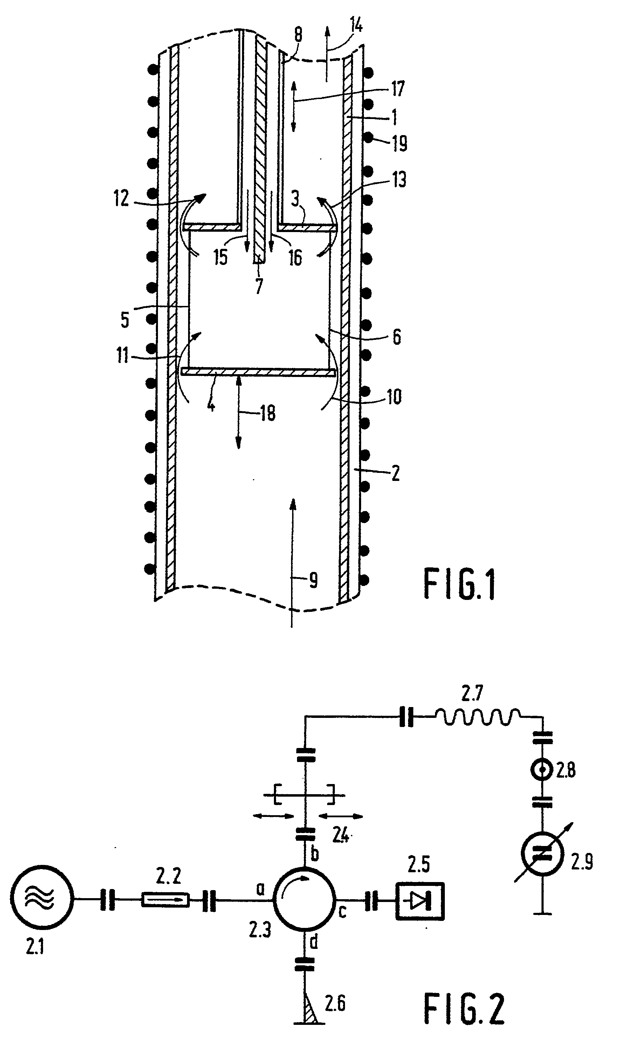

In Fig. 2 ist der zu Fig. I bzw. zu obigem Beispiel zugehörige Mikrowellenaufbau als Schaltschema dargestellt. Aus einem Geinerator 2.I (z.B. einem Klystron oder Karzinotron) gelangt Mikrowellenleistung über einen Isolator 2.2 in einen Vierweg-Zirkulator 2.3, wo die in einen Ast b gelangende Leistung über einen E-H-Tuner 2.4 so abgestimmt wird, daß die über ein flexibles Hohlleiterstück 2.7 und eine Koaxialleitung 2.8 in den Hohlraumresonator 2.9 mit dem Mikrowellenplasma eingekoppelte Leistung maximal wird. Das bedeutet, daß die Abstimmung des E-H-Tuners 2.4 so erfolgt, daß die in einer Detektor-Diode 2.5 nachgeweseine Leistung minimal wird. Aus einem Ast c nach einem Zweig d reflektierte Mikrowellen werden in einem Sumpf 2.6 absorbiert und gelangen nicht mehr zurück auf den Generator 2.I. Der Isolator 2.2 dient als zusätzliche Rücklaufdämpfung, so daß die Stabilität des Geinerators nicht gestört wird. Der gleiche Aufbau ist übrigens auch für das noch folgende Beispiel 2 verwendbar.

Zur Dimensionierung der Vorrichtung nach Fig. I und auch bezüglich der Wahl der Anregungsfrequenz sei hier noch ein Zahlenbeispiel angegeben: Geht man z.B. von einem Verhältnis D/L von I:I,29 aus, so folgt aus der Modenkarte in Baden-Fuller "Mikrowellen" S. I0I, daß für den $TM_{011}$-Mode die Bedingung

$$(f.D)^2 = 9.10^{16} \text{ m}^2.\text{Hz}^2$$

gilt. Für D = 30 mm folgt dann
f = $3.10^8$ Hz.m/0,03 m = $10^{10}$ Hz. Die Anregung erfolgt dann also mit einem abstimmbaren X-Band-Geinerator mit Frequenz im Bereich I0 GHz mit typischen Leistungen zwischen I00 und 300 Watt CW.

Dasselbe Ergebnis zur Dimensionierung des Resonators kann auch auf andere Weise erhalten werden. Fest vorgegeben ist wiederum D = 30 mm. Daraus können zunächst die Grenzwellenlängen

$$\lambda_G^{TM_{nm}}$$

für verschiedeine Wellentypen $TM_{nm}$ bestimmt werden. Es gilt

$$\lambda_G^{TM_{nm}} = \frac{2\pi \, v}{\gamma_{nm}} \, ,$$

wobei $\gamma_{nm}$ die mte Nullstelle der Besselfunktion $l_n$ angibt. Für $TM_{01}$ gilt $\gamma_{01} = 2,405$ und damit

$$\lambda_G = \frac{2\pi \cdot 1,5 \text{cm}}{2,405 \text{ cm}} = 3,919 \text{ cm}$$

Dies bedeutet, daß in einem solchen Hohlleiter nur Wellen dieses Typs mit einer Vakuumwellenlänge $\lambda < \lambda_G$ ausbreitungsfähig sind. Es gilt also

$$\nu > \nu_G = \frac{c}{\lambda_G}$$

für die Frequenz Mikrowelle. Setzt man nun $\nu$ nach dieser Bedingung fest auf l0,0 GHz, so erhält man als Hohlrohrwellenlänge $\Lambda$ für den $TM_{01}$-Typ im kreiszylindrischen Hohlleiter

$$\Lambda = \frac{\lambda}{\sqrt{1-(\lambda/\lambda_G)^2}}$$

oder $\Lambda = 4{,}663$ cm. Die Resonanzbedingung für den kreiszylindrischen Hohlraumresonator impliziert nun

$$L = p \cdot \frac{\Lambda}{2} ,$$

d.h. die Höhe L des Zylinders muß ein ganzzahliges Vielfaches von

$$\frac{\Lambda}{2}$$

sein. Für die $TM_{011}$-Schwingung bedeutet das per definitionem $L_1 = 2{,}33l$ cm, für $TM_{012}$ entsprechend $L_2 = 4{,}663$ cm. Anzumerken ist, daß der Resonator $(d, L_1)$ nicht nur eine bestimmte Eigenfrequenz hat, sondern je nach Modentypanregung insgesamt eine abzählbar unendliche Folge von Eigenfrequenzen. Z.B. ist für obigen Resonator die Resonanzfrequenz für den $TM_{010}$-Mode: $\nu TM_{010} \approx 7{,}6l$ GHz und für den $TE_{111}$-Mode 8,43 GHz. (Vergl.: G. Klages "Einführung in die Mikrowellenphysik" (Darmstadt l967)).

Beispiel 2

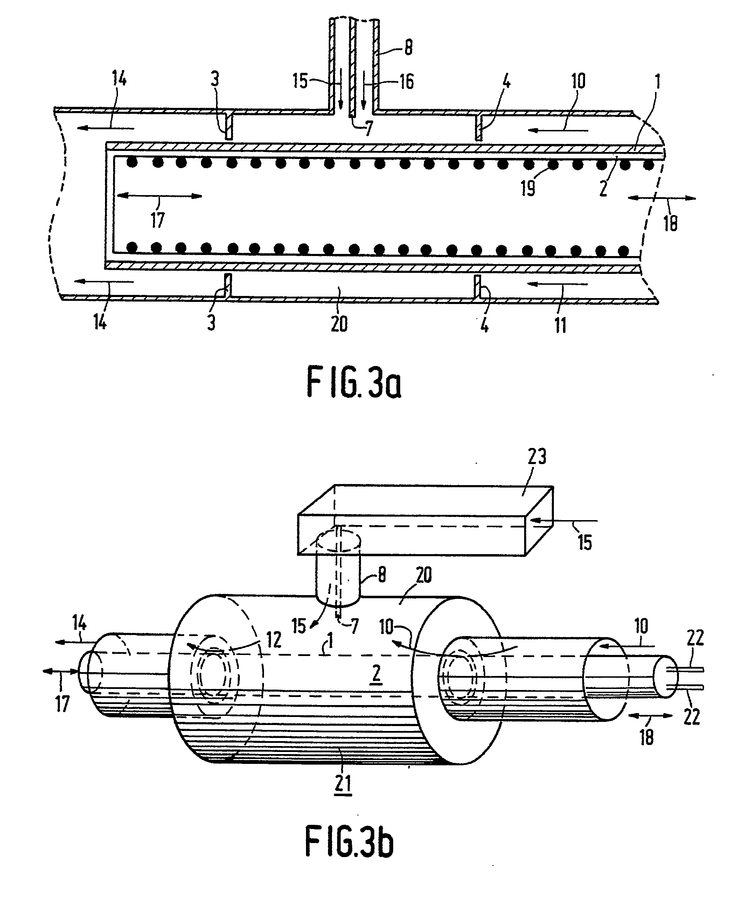

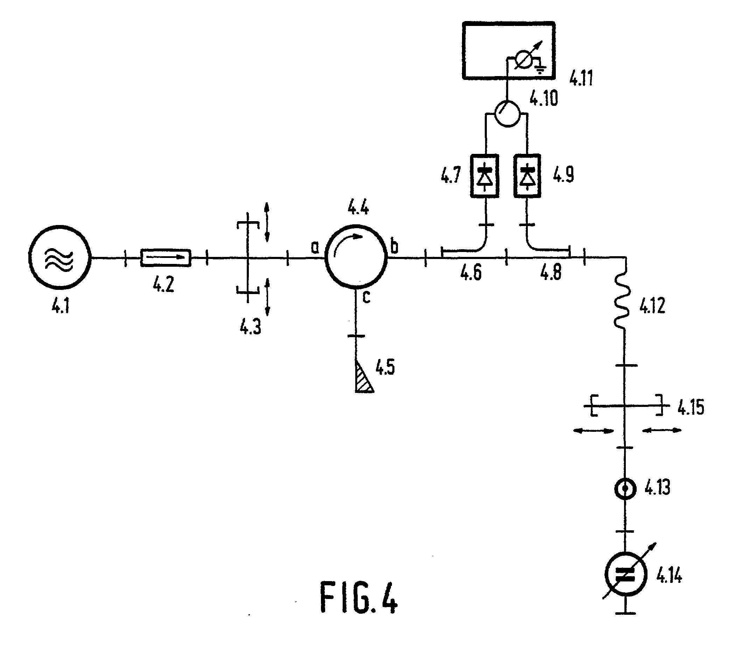

Es wird ein koaxialer Mikrowellenresonator verwendet, wie er in Fig. 3a und 3b dargestellt ist. In diesem Fall ist die Resonatoraußenwand 20 mit den Endplatten 3 und 4 stationär und der Innenzylinder 2, auf dem die Substratrohre l sitzen, wird periodisch durch den Resonator hindurch hin- und herbewegt, wobei der Hub ein Mehrfaches der Resonatorlänge beträgt. Die reaktiven Gase (Pfeile l0 und ll) strömen durch den ringförmigen Schlitz zwischen den Endplatten 3 und 4 und dem Substratrohr l in den Resonator 2l. Das Innenrohr 2 wird durch Heizwicklungen l9 mit Heizstromzuführungen 22 vorgeheizt. Abgepumpt (Pfeil l2) wird durch den entsprechenden Ringschlitz auf der gegenüberliegenden Resonatorseite. Zur Herstellung des elektrischen Kontaktes zwischen dem Substratrohr l und den Resonatorendplatten 3 und 4 empfiehlt es sich, zwischen dem Substratrohr und den Resonatorendplatten einen bürstenförmigen Schleifkontakt (nicht dargestellt) anzubringen, der zudem noch eine feinkörnige Abscheidung bewirkt. Die Mikrowellenleistung wird über einen Rechteckhohlleiter 23 und ein koaxiales Verbindungsstück 8 in den Resonator 2l eingespeist, in dem das Plasma brennt. Zur Anregung der TEM-Grundschwingung (Lecher-Typ) des koaxialen Resonators dient als Koppelstift 7 in radialer Richtung der verlängerte Innenleiter der Koaxialleitung.

Es sind aber auch andere Einkopplungen möglich, z.B. durch ein Koppelloch oder durch Verbindung des Koaxialinnenleiters mit der Resonatoraußenwand in der Ebene senkrecht zur Achse. In diesem Fall wird ein longitudinales H-Feld und damit wiederum ein transversales elektrisches Mikrowellenfeld angeregt. Die niedrigsten TE-Moden werden bevorzugt, da nur die E-Feld-Komponenten zur Oberfläche erwünscht sind und E-Ringfelder nur über V×E und E×H-Driftbewegungen sinnvoll zu gerichteter Ionenbewegung eingesetzt werden können. Natürlich kann das Verfahren auch mit TM-Moden durchgeführt werden. Je nach Zielrichtung kann man auch mit geeigneten höheren Moden längere Diffusionswege und eine Erhöhung der Zahl der Stöße im Gasraum erreichen. Höhere Moden haben allerdings den Vorteil, daß der Hub der Relativbewegung verringert werden kann, da es in den Feldknoten dann mehrere lokale erhöhte Plasmakonzentrationen gibt und dadurch ein schnellerer (Dickenund Konzentrations-)Profilausgleich erfolgt. Zur Dimensionierung gelten folgende Randbedingungen: Werden der Radius des Innenzylinders mit $r_i$, der Radius des Außenzylinders des Resonators mit $r_a$ und die Resonatorlänge mit L bezeichnet, so gilt als Bedingung nur für den TEM-Mode, d.h. rein transversales elektrisches Feld und rein transversales magnetisches Feld

$$\pi \cdot (r_i + r_a) < \lambda_0 \quad \text{und} \quad L = n \cdot \frac{\lambda}{2}$$

(vergl. G. Nimtz "Mikrowellen" (München l980) S. 39).

Für $r_i = l{,}5$ cm und $r_a = l{,}5\, r_i$ erhält man $\lambda_0 > l l{,}2$ oder $\nu_0 < 2{,}7$ GHz. Mit $\nu_0 = 2{,}45$ GHz folgt dann $L = l/2$. $\lambda_0 = 6{,}l$ cm. Diese Wahl von $\nu_0$ hat rein technische Gründe. Setzt man statt $r_a = l{,}5\, r_i$ den bezüglich Güte optimalen Wert von $r_a = 3{,}6\, r_i$ ein, so erhält man als Frequenzbedingung $\nu_0 < l{,}4$ GHz und L wird doppelt so groß, was bezüglich der räumlichen Plasmakonzentration wiederum ungünstiger ist. Will man statt dessen eine größere lokale Plasmakonzentration im Grundmode erreichen und ist z.B. auf einen Substratrohrdurchmesser $r = l{,}5$ cm festgelegt, so kann nun $r_a = l{,}5$ cm und $r_i = 0{,}5$ cm gewählt werden. Das jetzt z.B. feststehende Substratrohr dient jetzt als Außenzylinder und wird zusätzlich von außen aufgeheizt. Das dünne Innenrohr bleibt unbeheizt und dient als koaxialer oder runder Hohlleiter zur Zuführung der Mikrowellenenergie in den Resonator, in dessen Mitte sich die mit Inertgas gespülte Einkopplung befindet und dessen Endplatten fest mit dem Innenrohr verbunden sind. Das Innenrohr mit den Endplatten wird nun periodisch hin- und herbewegt. Die reaktiven Gase strömen durch den Ringschlitz zwischen Endplatten und Substratrohr in den Resonator und werden auf der anderen Seite ebenso abgesaugt. Mit den obigen Abmessungen erhält man nun

$$\pi \cdot (r_i + r_a) = 6,28 \text{ cm} < \lambda_0 \text{ oder } \nu_0 < 4,77 \text{ GHz}.$$

Mit $\nu_0 = 4,7$ GHz folgt dann für den TEM-Grundmode L = 3,2 cm. Man hat also mit dieser Anordnung eine bessere lokale Plasmakonzentration erreicht.

Fig. 4 zeigt eine Alternative zum Mikrowellenaufbau nach Fig. 2. Vorteilhaft ist hierbei, daß hin- und rücklaufende Wellen getrennt gemessen werden und so die im Resonator verbrauchte Leistung bestimmt werden kann. Aus einem Geinerator 4.l, z.B. einem Magnetron oder Klystron, gelangt Mikrowellenleistung über einen Isolator 4.2 und einen E-H-Abstimmer 4.3 in einen 3-Weg-Zirkulator 4.4 (Eingang a). Die im Ausgang b ausgekoppelten Mikrowellen gelangen über ein flexibles Hohlleiterstück 4.l2 und einen koaxialen Hohlleiter 4.l3 in einen mit dem Reaktionsraum (einer Plasmakammer) identischen Hohlraumresonator 4.l4.

Es empfiehlt sich, vor den Resonator einen weiteren E-H-Abstimmer 4.l5 (bzw. einen Stifttransformator oder eine Quetschleitung) einzusetzen. Die Bestimmung der Leistungseinkopplung in das Plasma erfolgt über die beiden 20dB-Richtkoppler für Vorlauf (4.6) und Rücklauf (4.8) und die beiden Detektoren 4.7 und 4.9. In einem Stehwellenmesser bzw. einem Leistungsmeßgerät 4.l0 kann entweder direkt das Differenzsignal zwischen vorlaufender und reflektierter Mikrowelle gebildet werden oder es wird über einen Schalter zwischen beiden Detektoren hin- und hergeschaltet. Die auf der Strecke zum Resonator reflektierte Leistung gelangt von b nach c und wird in einem Sumpf 4.5 absorbiert.

Typische Abscheidebedingungen, z.B. für eine W + $ThO_2$-Abscheidung, sind:

$WF_6$-Durchflußrate l0 bis 60 sccm (= cm³ pro Minute, bezogen auf Normalbedingungen (0°C, l0l3 hPa)), $H_2$-Durchflußrate l00 bis 600 sccm, Ar-Fluß l00 bis 400 sccm, Sättigertemperatur l40°C, Sättigerfüllung Th-tetrakis(heptafluordimethyloctandionat), Substratrohrtemperatur 250 bis 500°C, Gesamtdruck im Reaktor 5 bis 30 hPa.

Bezüglich der Resonatorkonfiguration gibt es eine Reihe von Kombinationsmöglichkeiten, z.B. von mehreren Resonatoren mit verschiedeinen reaktiven Füllgaszusammensetzungen, die gemeinsam über das gemeinsame Substratrohr hinweg verschoben werden, um so eine gewünschte Schichtstruktur zu erzielen.

Eine weitere Variante besteht darin, daß man unter für sehr hohe bzw. nahezu quantitative Ausbeuten geeigneten Bedingungen auf das Spülgas für die Mikrowellenzuführungen verzichtet und statt dessen über die Einkoppelstelle abpumpt.

Das erfndungsgemäße Verfahren kann bei allen per CVD-Verfahren herstellbaren elektrisch leitenden Schichtstrukturen angewendet werden und ermöglicht somit deren Herstellung durch mikrowellenplasmaaktivierte CVD-Verfahren.

Zusammengefaßt besteht die Erfindung darin, daß elektrisch leitende Schichten und Formkörper durch mikrowellenplasmaaktivierte chemische Abscheidung aus der Gasphase in einem stehenden Mikrowellenfeld abgeschieden werden. Die Abscheidung erfolgt auf einer elektrisch leitenden Unterlage, bei der ein Teil der Oberfläche einen Teil der Innenwandung eines Mikrowellen-Hohlraumresonators bildet. Dadurch wird die Mikrowellenenergie optimal ausgenutzt. Es werden Maßnahmen getroffen, um die Einkoppelstelle der Mikrowellen ("Fenster") von einem elektrisch leitenden Bewuchs freizuhalten. Vorzugsweise wird die Unterlage relativ zum Plasma und zur übrigen Wandung des Resonators periodisch oder aperiodisch verschoben.

## Patentansprüche

l. Verfahren zur Herstellung eines Formkörpers aus mindestens einem elektrisch leitenden Werkstoff durch eine plasmaaktvierte chemische Abscheidung des Werkstoffs aus einer mindestens eine Ausgangsverbindung des Werkstoffs enthaltenden Gasphase auf einer aus einem zweiten elektrisch leitenden Werkstoff bestehenden Unterlage, die anschließend entfernt wird, dadurch gekennzeichnet, daß die Gasphase in einen als Mikrowellen-Hohlraumresonator ausgebildeten Reaktionsraum eingeleitet wird, dessen Innenwandung zum Teil aus zumindest einem Teil der Unterlage besteht, auf der der elektrisch leitende Werkstoff abgeschieden wird, und daß dem Reaktionsraum an einer Stelle, die von aufwachsendem elektrisch leitendem Werkstoff freigehalten wird, Mikrowellen zugeführt werden, durch die ein stehendes Mikrowellenfeld im Reaktionsraum erzeugt wird.

2. Verfahren nach Anspruch l, dadurch gekennzeichnet, daß die Frequenz der dem Reaktionsraum zugeführten Mikrowellen mit einer der Resonanzfrequenzen des als Mikrowellen-Hohlraumresonator ausgebildeten Reaktionsraumes n Übereinstimmung gebracht wird.

3. Verfahren nach Anspruch 2, dadurch gekennzeichnet, daß ein einziger ganz bestimmter Resonatormode über eine jeweils passend gewählte abstimmbare Einkoppelvorrichtung aus einem die Mikrowellen führenden Hohlleiter angeregt wird.

4. Verfahren nach Anspruch 3, dadurch gekennzeichnet, daß ein transversaler elektrischer Wellentyp ($TE_{nmp}$-Wellentyp) angeregt wird, bei dem ein Bauch oder mehrere Bäuche der senkrecht auf der Oberfläche der Unterlage endenden elektrischen Feldvektoren der Mikrowelle sich längs der Unterlage erstrecken.

5. Verfahren nach Anspruch l, dadurch gekennzeichnet, daß Schichten aus elektrisch leitendem Werkstoff auf der Innenwandung eines rotationssymmetrischen Hohlraumresonators abgeschieden werden.

6. Verfahren nach Anspruch l, dadurch gekennzeichnet, daß die Schichten auf der Innenwandung eines rechteckigen Hohlraumresonators abgeschieden werden.

7. Verfahren nach Anspruch l, dadurch gekennzeichnet, daß die Schichten auf der Innenwandung eines kugelförmigen Hohlraumresonators abgeschieden werden.

8. Verfahren nach Anspruch 5, 6 oder 7, dadurch gekennzeichnet, daß die Güte des leeren Hohlraumresonators mindestens l00 beträgt.

9. Verfahren nach Anspruch 2 oder 3, dadurch gekennzeichnet, daß die Mikrowellenfrequenz und die Resonatorfrequenz 'für den gewählten Modentyp durch mechanische und/oder elektrische Nachstimmung während der Abscheidung in Resonanz gehalten wird. ·

l0. Verfahren nach Anspruch l, dadurch gekennzeichnet, daß die Stelle, an der dem Reaktionsraum Mikrowellenenergie zugeführt wird, durch Einleiten eines Spülgases oder durch Einbau eines selektiv nicht beschichtbaren Isolators an dieser Stelle von aufwachsenden elektrisch leitenden Schichten freigehalten wrd.

ll. Verfahren nach Anspruch l, dadurch gekennzeichnet, daß die nach außen verlängerte Unterlage relativ zum Plasma und zur übrigen Wandung des Reaktionsraumes periodisch oder aperiodisch verschoben wird.

l2. Verfahren nach Anspruch l oder ll, dadurch gekennzeichnet, daß ein Hohlraumresonator verwendet wird, dessen Öffnungen für Gaseintritt, Gasaustritt, Mikrowelleneinkopplung und gegebenenfalls Schleifkontaktverbindung für die Verschiebung möglichst klein gehalten werden.

## Claims

1. A method of manufacturing a moulded body of at least an electrically conductive material by a plasma-activated chemical deposition of the material from a gas phase comprising at least a starting compound of the material on a substrate consisting of a second electrically conductive material, which substrate is then removed, characterized in that the gas phase is introduced into a reaction space which is constructed as a microwave cavity resonator whose inner wall consists partly of at least a part of the substrate on which the electrically conductive material is deposited, and that microwaves are applied to the reaction space at a location which is kept free from growing electrically conductive material, said microwaves producing a standing microwave field in the reaction space.

2. A method as claimed in claim 1, characterized in that the frequency of the microwaves applied to the reaction space is made to match one of the resonant frequencies of the reaction space constructed as a microwave cavity resonator.

3. A method as claimed in claim 2, characterized in that a single particular resonator mode is obtained via a suitably chosen tunable coupling device from a wavequide guiding the microwaves.

4. A method as claimed in claim 3, characterized in that a transversal electric wave type ($TE_{nmp}$-wave type) is excited, with a bulge or several bulges of the electric field vectors of the microwave terminating at right angles to the surface of the substrate extending along the substrate.

5. A method as claimed in claim 1, characterized in that layers of an electrically conductive material are deposited on the inner wall of the rotationally symmetrical cavity resonator.

6. A method as claimed in claim 1, characterized in that the layers are deposited on the inner wall of a rectangular cavity resonator.

7. A method as claimed in claim 1, characterized in that the layers are deposited on the inner wall of a spherical cavity resonator.

8. A method as claimed in claim 5, 6, or 7, characterized in that the Q-factor of the cavity resonator is at least 100.

9. A method as claimed in claim 2 or 3, characterized in that the microwave frequency and the resonator frequency for the selected mode type are kept resonating by mechanical and/or electrical retuning during the deposition.

10. A method as claimed in claim 1, characterized in that the place at which microwave energy is applied to the reaction space is kept free from growing electrically conductive layers by introducing a rinsing gas or by incorporating a selective by non-coatable insulator.

11. A method as claimed in claim 1, characterized in that the outwardly elongated substrate is moved periodically or aperiodically relative to the plasma and the remaining wall of the reaction space.

12. A method as claimed in claim 1 or 11, characterized in that a cavity resonator is used whose apertures for gas inlet, gas outlet, microwave coupling and, optionally, sliding contact connection for the displacement are kept as small as possible.

## Revendications

1. Procédé pour la fabrication d'un corps façonné en au moins un matériau électroconducteur par dépôt chimique activé par plasma du matériau à partir d'une phase gazeuse contenant au moins un composé de départ du matériau sur un substrat qui est constitué par un deuxième matériau électroconducteur et qui est ensuite enlevé, caractérisé en ce que la phase gazeuse est introduite dans une enceinte de réaction formée comme cavité résonante à micro-ondes dont la paroi intérieure est partiellement constituée par au moins une partie du substrat sur laquelle est déposé le matériau électroconducteur et en ce que des micro-ondes sont amenées à l'enceinte de réaction à un endroit maintenu exempt du matériau électroconducteur en croissance et engendrent un champ de micro-ondes stationnaire dans l'enceinte de réaction.

2. Procédé selon la revendication 1, caractérisé en ce que la fréquence des micro-ondes amenées à l'enceinte de réaction est mise en accord avec l'une des fréquences de résonance de l'enceinte de réaction formée comme cavité de résonance à micro-ondes.

3. Procédé selon la revendication 2, caractérisé en ce qu'un seul mode de résonateur entièrement déterminé est excité par l'intermédiaire d'un dispositif de couplage accordable choisi chaque fois de façon appropriée à partir d'un guide d'ondes traversé par les micro-ondes.

4. Procédé selon la revendication 3, caractérisé en ce qu'un mode d'ondes transversales électriques (mode d'ondes TE$_{nmp}$) est excité pour lequel un ventre ou plusieurs ventres des vecteurs de champ électrique des micro-ondes se terminant perpendiculairement à la surface du substrat s'étendent le long du substrat.

5. Procédé selon la revendication 1, caractérisé en ce que des couches en matériau électroconducteur sont déposées sur la paroi intérieure d'une cavité résonante à symétrie de révolution.

6. Procédé selon la revendication 1, caractérisé en ce que les couches sont déposées sur la paroi intérieure d'une cavité résonante rectangulaire.

7. Procédé selon la revendication 1, caractérisé en ce que les couches sont déposées sur la paroi intérieure d'une cavité résonante en forme de boule.

8. Procédé selon la revendication 5, 6 ou 7, caractérisé en ce que le facteur de qualité de la cavité résonante vide est d'au moins 100.

9. Procédé selon la revendication 2 ou 3, caractérisé en ce que la fréquence des micro-ondes et la fréquence du résonateur pour le type de mode d'ondes choisi sont maintenues en résonance par accordage postérieur mécanique et/ou électrique pendant le dépôt.

10. Procédé selon la revendication 1, caractérisé en ce que l'endroit auquel de l'énergie de micro-ondes est amenée à l'enceinte de réaction est maintenu exempt des couches électroconductrices en croissance par introduction d'un gaz de rinçage ou par disposition d'un isolateur ne pouvant pas être recouvert sélectivement à cet endroit.

11. Procédé selon la revendication 1, caractérisé en ce que le substrat prolongé vers l'extérieur est déplacé périodiquement ou apériodiquement par rapport au plasma et au reste de la paroi de l'enceinte de réaction.

12. Procédé selon la revendication 1 ou 11, caractérisé par l'utilisation d'une cavité résonante dont les ouvertures pour l'entrée du gaz, l'éévacuation du gaz, l'introduction des micro-ondes et, le cas échéant, le contact à frottement pour le déplacement sont maintenues aussi petites que possible.

FIG.1

FIG.2

FIG.3a

FIG.3b

FIG.4